(19) Europäisches Patentamt
European Patent Office
Office européen des brevets

(11) EP 4 697 034 A1

(12) EUROPEAN PATENT APPLICATION

(43) Date of publication:
18.02.2026 Bulletin 2026/08

(51) International Patent Classification (IPC):
$G01R\ 29/08^{(2006.01)}$

(21) Application number: 25186699.2

(52) Cooperative Patent Classification (CPC):
G01R 29/0857; G01R 29/0814

(22) Date of filing: 01.07.2025

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
GE KH LA MA MD TN

(30) Priority: 16.08.2024 US 202418806774

(71) Applicant: INTEL Corporation
Santa Clara, CA 95054 (US)

(72) Inventors:
• EL HAJJ, Walid
06600 Antibes (FR)
• ROMAN, John
Hillsboro, OR, 97124 (US)
• ASRIH, Nawfal
06600 Mandelieu-la-Napoule (FR)

(74) Representative: Viering, Jentschura & Partner mbB
Patent- und Rechtsanwälte
Am Brauhaus 8
01099 Dresden (DE)

(54) **DEVICE AND METHOD FOR DETERMINING INCIDENT POWER DENSITY REFERENCE LEVEL EXPOSURES FROM SPECIFIC ABSORPTION RATE MEASUREMENTS**

(57) An incident power density determination device includes a human tissue phantom, configured to approximate dielectric properties of human tissue; one or more radiofrequency probes, positioned within the human tissue phantom, configured to generate measurements of radiofrequency emissions absorbed within the human tissue phantom; and a processor, configured to determine an incident power density at an outer surface of the human tissue phantom based on the generated measurements of the radiofrequency emissions.

FIG. 2

## Description

### Technical Field

Various aspects of this disclosure generally relate to the measurement of Specific Absorption Rate (SAR) and the conversion of SAR to Incident Power Density (IPD), such as for regulatory compliance.

### Background

Wireless communication devices (e.g. cellular phones, Wi-Fi, etc.) emit non-ionizing radiation, often with non-trivial power, and many of these devices are conventionally used in close proximity to the human body. As a result, various restrictions exist to limit human exposure to radiofrequency radiation from wireless communication devices. These restrictions generally take the form of statutes or regulations in a given legal jurisdiction. In some cases, the statutes or regulations may be derived from, or otherwise guided by, international safety standards or guidelines. For example, the International Commission on Non-Ionizing Radiation Protection (ICNIRP) and the Technical Committee (TC) 95 of the International Commission on Electromagnetic Safety (ICES) of the Institute of Electrical and Electronics Engineers (IEEE) promulgate guidelines relative to human exposure to non-ionizing radiation from wireless communication devices.

Certain advisory and regulatory bodies have distinguished between frequencies less than 6 GHz frequencies above 6 GHz and have recommended or instituted different requirements for limits of non-ionizing radiation from wireless communication devices based on whether the transmitted frequency is greater than or less than 6 GHz. For example, the ICNIRP and the ICES have recommended that exposure to non-ionizing radiation from wireless communication devices be limited based on measurements of Specific Absorption Rate (SAR) for frequencies up to 6 GHz and based on Power Density (PD) for frequencies greater than 6 GHz. Moreover, previous recommendations were to measure absorbed power density (APD) above 6 GHz, whereas certain guidelines now recommend, and certain jurisdictions now require, measurement of incident power density (IPD) rather than APD. For clarity, APD was defined as the basic restriction (BR) for ICNIRP, and the epithelial power density (EPD) was defined as the dosimetric reference limit (DRL) for IEEE. The equivalent incident power density (IPD) in free space is conservatively defined as the reference level (RL) for ICNIRP or exposure reference level (ERL) for IEEE. In the US, the limits provided by the Federal Communication Commission (FCC) also specify the measurement of SAR below 6 GHz and the measurement of IPD above 6 GHz, albeit with different exposure limits.

At the same time, new wireless technologies such as the fifth-generation technology standard for cellular networks (5G) and the IEEE standard 801.11x, which includes Wi-Fi® 6E and 7, utilize more and more radiofrequency (RF) spectrum around 6 GHz. One of the main challenges for RF- or electromagnetic-frequency (EMF) exposure assessments stems from this change in exposure metrics-that is, measuring SAR, which is an internal quantity, until 6 GHz and measuring IPD, which is an external quantity, thereafter. As a practical matter, a device's compliance limit is generally defined in terms of IPD above the 6 GHz range, while compliance is generally defined in terms of SAR at or below 6 GHz.

Many wireless communication devices operate above and below 6 GHz. For example, various wireless local area network (WLAN) products operate in the 2.4 GHz, 5.15-5.925 GHz and 6-7.125 GHz bands. For devices capable of transmitting above 6 GHz, certain jurisdictions require testing in the >6GHz bands by first performing SAR measurement for all configurations and then testing IPD for the highest SAR test configurations. Thus, certain jurisdictions require measurements of both SAR and IPD for certain bands. This in turn results in greater effort and testing time, which corresponds to greater expense and time to market. Moreover, IPD measurements have additional technical complexities related to reconstruction of the magnetic field from the measured Electric field, and these additional technical complexities increase the testing time (IPD measurement takes around 25 times longer than SAR measurement). IPD measurements may also increase the measurement uncertainty (27% measurement uncertainty for SAR, compared to 85% measurement uncertainty for IPD).

### Brief Description of the Drawings

In the drawings, like reference characters generally refer to the same parts throughout the different views. The drawings are not necessarily to scale, emphasis instead generally being placed upon illustrating the exemplary principles of the disclosure. In the following description, various exemplary embodiments of the disclosure are described with reference to the following drawings, in which:

FIG. 1 depicts a procedure for calculating IPD from SAR;
FIG. 2 depicts a SAR measurement configuration;
FIG. 3 depicts the comparison of the calculated incident power density values to the measured incident power density values;

FIG. 4 depicts the deviation in dB between measured power density and calculated power density;

FIG. 5 depicts a method of incident power density determination; and

FIG. 6 depicts an incident power density determination device according to an aspect of the disclosure.

## Description

The following detailed description refers to the accompanying drawings that show, by way of illustration, exemplary details and embodiments in which aspects of the present disclosure may be practiced.

The word "exemplary" is used herein to mean "serving as an example, instance, or illustration". Any embodiment or design described herein as "exemplary" is not necessarily to be construed as preferred or advantageous over other embodiments or designs.

Throughout the drawings, it should be noted that like reference numbers are used to depict the same or similar elements, features, and structures, unless otherwise noted.

The phrase "at least one" and "one or more" may be understood to include a numerical quantity greater than or equal to one (e.g., one, two, three, four, [...], etc.). The phrase "at least one of" with regard to a group of elements may be used herein to mean at least one element from the group consisting of the elements. For example, the phrase "at least one of" with regard to a group of elements may be used herein to mean a selection of: one of the listed elements, a plurality of one of the listed elements, a plurality of individual listed elements, or a plurality of a multiple of individual listed elements.

The words "plural" and "multiple" in the description and in the claims expressly refer to a quantity greater than one. Accordingly, any phrases explicitly invoking the aforementioned words (e.g., "plural [elements]", "multiple [elements]") referring to a quantity of elements expressly refers to more than one of the said elements. For instance, the phrase "a plurality" may be understood to include a numerical quantity greater than or equal to two (e.g., two, three, four, five, [...], etc.).

The phrases "group (of)", "set (of)", "collection (of)", "series (of)", "sequence (of)", "grouping (of)", etc., in the description and in the claims, if any, refer to a quantity equal to or greater than one, i.e., one or more. The terms "proper subset", "reduced subset", and "lesser subset" refer to a subset of a set that is not equal to the set, illustratively, referring to a subset of a set that contains less elements than the set.

The term "data" as used herein may be understood to include information in any suitable analog or digital form, e.g., provided as a file, a portion of a file, a set of files, a signal or stream, a portion of a signal or stream, a set of signals or streams, and the like. Further, the term "data" may also be used to mean a reference to information, e.g., in form of a pointer. The term "data", however, is not limited to the aforementioned examples and may take various forms and represent any information as understood in the art.

The terms "processor" or "controller" as, for example, used herein may be understood as any kind of technological entity that allows handling of data. The data may be handled according to one or more specific functions executed by the processor or controller. Further, a processor or controller as used herein may be understood as any kind of circuit, e.g., any kind of analog or digital circuit. A processor or a controller may thus be or include an analog circuit, digital circuit, mixed-signal circuit, logic circuit, processor, microprocessor, Central Processing Unit (CPU), Graphics Processing Unit (GPU), Digital Signal Processor (DSP), Field Programmable Gate Array (FPGA), integrated circuit, Application Specific Integrated Circuit (ASIC), etc., or any combination thereof. Any other kind of implementation of the respective functions, which will be described below in further detail, may also be understood as a processor, controller, or logic circuit. It is understood that any two (or more) of the processors, controllers, or logic circuits detailed herein may be realized as a single entity with equivalent functionality or the like, and conversely that any single processor, controller, or logic circuit detailed herein may be realized as two (or more) separate entities with equivalent functionality or the like.

As used herein, "memory" is understood as a computer-readable medium (e.g., a non-transitory computer-readable medium) in which data or information can be stored for retrieval. References to "memory" included herein may thus be understood as referring to volatile or non-volatile memory, including random access memory (RAM), read-only memory (ROM), flash memory, solid-state storage, magnetic tape, hard disk drive, optical drive, 3D XPointTM, among others, or any combination thereof. Registers, shift registers, processor registers, data buffers, among others, are also embraced herein by the term memory. The term "software" refers to any type of executable instruction, including firmware.

Unless explicitly specified, the term "transmit" encompasses both direct (point-to-point) and indirect transmission (via one or more intermediary points). Similarly, the term "receive" encompasses both direct and indirect reception. Furthermore, the terms "transmit," "receive," "communicate," and other similar terms encompass both physical transmission (e.g., the transmission of radio signals) and logical transmission (e.g., the transmission of digital data over a logical software-level connection). For example, a processor or controller may transmit or receive data over a software-level connection with another processor or controller in the form of radio signals, where the physical transmission and reception is handled by radio-layer components such as RF transceivers and antennas, and the logical transmission and reception over the software-level connection is performed by the processors or controllers. The term "communicate" encompasses one or both of transmitting and receiving, i.e., unidirectional or bidirectional communication in one or both of the incoming and outgoing directions. The term "calculate" encompasses both 'direct' calculations via a mathematical expression/-formula/relationship and 'indirect' calculations via lookup or hash tables and other array indexing or searching operations.

Throughout this disclosure, the term human tissue phantom is intended to reflect any device that is composed of or that comprises materials that mimic the dielectric characteristics of human tissue, which may be used for measurement of absorption of electromagnetic emissions. A human tissue phantom may take many forms. In some circumstances, the human tissue phantom may mimic the shape or dimensions of a body part, such as a human head, a human torso, or other human appendage. The human tissue phantom may be filled with salt water having a salinity that mimics the dielectric properties of human tissue. The human tissue phantom may be filled with one or more other materials in addition to salt water or as an alternative to salt water. Human tissue phantoms are known and routinely used for SAR testing, and any known human tissue phantom may be used for the purposes of this disclosure.

Although the human tissue phantom may generally mimic the dielectric properties of human tissue, the human tissue phantom may be selected to specifically mimic the dielectric properties of human tissue at frequencies at or greater than 6 GHz. As the frequency of an electromagnetic emission increases, its influence on human tissue changes. That is, higher frequency emissions (e.g., at or above 6 GHz) may penetrate human tissue less than lower frequency emissions. High frequency emissions may, however, carry more energy and may thus have other effects on human tissue, such as increased thermal changes compared to lower frequencies. The human tissue phantom for the tests as described herein may be selected to more closely mimic the effects of a radiofrequency emission of 6 GHz or greater on human tissue. For example, the human tissue phantoms may be designed to simulate the surface properties of human skin rather than bulk tissue properties (e.g., brain tissue, muscle tissue) that might otherwise be of greater relevance at fewer than 6 GHz.

Radiofrequency (RF) transmissions (e.g. such as from a cellular phone) emit electromagnetic waves that consist of oscillating electric fields and magnetic fields and that propagate through space. When an RF wave encounters a solid body, the RF wave includes an electric field within the solid body, as a result of the oscillating electric field component of the RF wave inducing a movement of charges within the solid body. The field strength of these induced electric fields may be measured. This electric field strength measurement may be used as described herein to determine the IPD.

IPD is a metric used to assess the exposure of humans to electromagnetic fields. It is typically spatially averaged over an area. IPD may be understood as the normal component of the electromagnetic field vectors crossing a barrier (e.g., from air to human tissue) or a magnitude of the IPD vectors averages over an area (e.g., an area of human tissue).

Although it is possible to measure IPD above 6 GHz directly, such measurements present multiple challenges, especially for low frequencies e.g. 6- 10 GHz. First, the physical measurement distances (e.g. 2mm, 5mm) are small compared to the wavelength in this band, and therefore, the measurements generally occur in the reactive near field of the device radiating source. This makes the measurement of the corresponding electric field and the reconstruction methods for the magnetic field less accurate and with higher measurement uncertainty. As such, the reconstruction methods to deduce the power density from the measured electric field requires a large scanning plane with a large number of points in the grid, not to mention significant post-processing procedure. This makes IPD measurement significantly more time consuming than SAR measurement.

Rather than measuring IPD according to the conventional method, IPD can be determined from the SAR. Specifically, as described herein, electromagnetism principles permit the electric field measured in the body (or SAR phantom) to be used to deduce the electric field that propagates in free space before penetrating the body. This determination of the IPD based on SAR measurements reduces the time to market by eliminating some or all need for time-consuming IPD measurements as described above. It reduces complexity and improves accuracy of human exposure measurement method used for product certification.

That is, instead of performing full measurement of IPD, a device and procedure for determining IPD from SAR measurements is disclosed, wherein the IPD is determined from the obtained electric field distribution at the surface between the free space (Air) and a human phantom (SAR liquid), and a body equivalent plane wave power density is calculated using liquid intrinsic impedance. The body equivalent plane wave power density is then used to calculate the free space equivalent power density (e.g. the IPD).

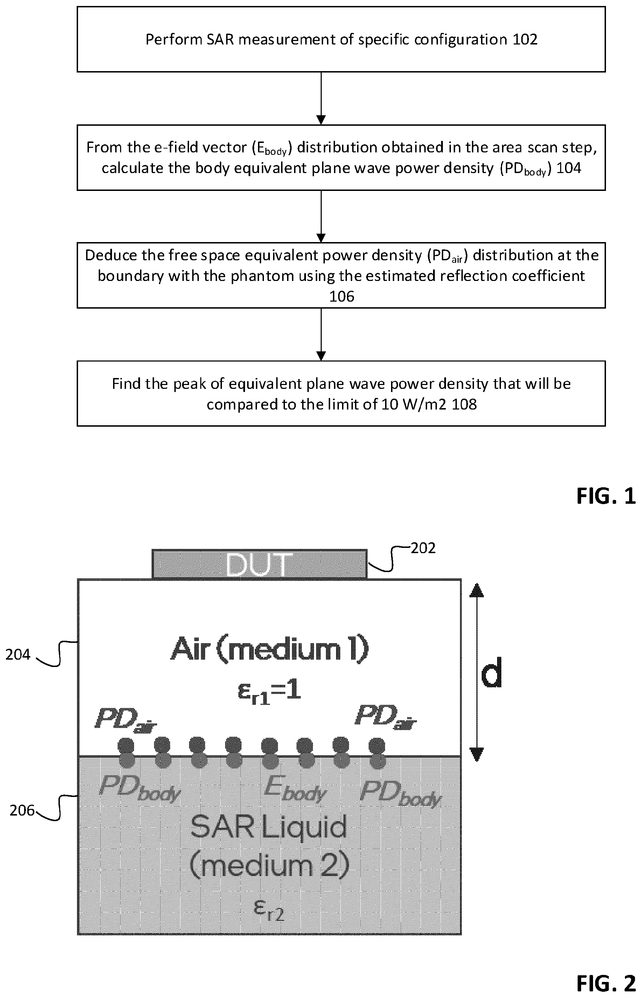

FIG. 1 depicts steps for calculating IPD from SAR. In this figure, the SAR measurement is performed at a specific configuration 102. That is, a human tissue phantom made of or containing one or more substances that approximate the dielectric properties of human tissue is exposed to an external source of non-ionizing radiation from radiofrequency emissions. To the extent that a singular human tissue phantom is described, any of the principles and methods disclosed herein may be applied to or performed using a plurality of human tissue phantoms.

One or more radiofrequency probes may measure the radiofrequency signal received within the human tissue phantom. In this manner, the underlying power density determining device may be configured to generate measurements of radiofrequency emissions absorbed by the human tissue phantom, such as by using one or more radiofrequency probes. The radiofrequency probes as described herein may be probes that are designed to measure the intensity of an electromagnetic field. Many such probes are isotropic, meaning that they can measure electric fields from all directions, although isotropic or non-isotropic probes may be used for the principles and methods disclosed herein. As described in greater detail, the probe may be part of, or inserted into, a human tissue phantom, where the probe will detect an electric field strength, which may manifest as a voltage induced in the probe's sensors by a surrounding electromagnetic field. Each reading corresponds to a magnitude of electric field measured at a given location within the human tissue phantom. By recording multiple measurements at a variety of locations, these multiple measurements form the basis of an electric field distribution in the measured area, which will be described herein as $E_{body}$. That is, multiple electric field measurements at different points within an area of the human tissue phantom provide information about the electric field distribution across that area. This process of electric field detection / measurement within a human tissue phantom may be a preliminary step in the measurement or determination of a SAR.

From the E-field vector ($E_{body}$) distribution obtained in the area scan step, the body equivalent plane wave power density ($PD_{body}$) is calculated 104. Although the specific principle and formula for this conversion will be described in greater detail below, the general procedure is to perform a point by point conversion from electric field to power density in body and in air. The free space equivalent power density ($PD_{air}$) distribution at the boundary with the phantom may be deduced using the estimated reflection coefficient 106. Finally, the peak of equivalent plane wave power density may be determined 108. This is the peak that will be compared to the regulatory limit, such as, for example, a limit of 10 W/m$^2$.

FIG. 2 depicts a SAR measurement configuration where a device under test (DUT) is placed at a specific separation distance from the human tissue phantom. The DUT is depicted as 202; the air between the DUT 202 and the human tissue phantom is depicted as 204; and the human tissue phantom (described in this figure as the SAR liquid) is depicted as 206. $E_{body}$ represents the measured E-field in SAR at the surface with air, which is determined based on, and corresponds to, the various measurement points of the area scan (e.g. the scan using the radiofrequency probes within the human tissue phantom). $PD_{body}$ represents the equivalent plane wave power density in body obtained at each point from $E_{body}$, as depicted in equation 1:

$$PD_{body} = \frac{\|E_{body}\|^2}{Z_{body}} = \frac{\|E_{body}\|^2}{\left(\frac{120\pi}{\sqrt{\varepsilon_{r2}}}\right)} \tag{1}$$

In this equation, $Z_{body}$ is the intrinsic impedance of the body medium which is the intrinsic impedance of free space (120\pi) divided by the medium index $n_2 = \sqrt{\varepsilon_{r2}}$. Further stating, $\varepsilon_{r1}=1$ is the dielectric permittivity in free space, and $\varepsilon_{r2}$ is the dielectric permittivity of the body with values measured during the liquid check of SAR measurement (e.g., measured in the human tissue phantom). $PD_{air}$ can be obtained at each measured point by dividing $PD_{body}$ by a transmission coefficient (T=1-R ) at the air-body surface (e.g. at the junction between the body of the human tissue phantom and the surrounding air). R is the reflection coefficient.

Since the distance d is physically small, the propagation is very close to a normal incidence scenario. Assuming this is true (e.g., assuming a small distance), then R can be estimated as:

$$R = \left|\frac{n_1 - n_2}{n_1 + n_2}\right|^2 = \left|\frac{1 - \sqrt{\varepsilon_{r2}}}{1 + \sqrt{\varepsilon_{r2}}}\right|^2 \tag{2}$$

Therefore the Power density in air $PD_{air}$ can be obtained from the $E_{body}$, the measured E-field in SAR, as follows:

$$PD_{air} = \frac{PD_{body}}{1-R} = \frac{PD_{body}}{1 - \left|\frac{1 - \sqrt{\varepsilon_{r2}}}{1 + \sqrt{\varepsilon_{r2}}}\right|^2} = \frac{\|E_{body}\|^2}{\left(\frac{120\pi}{\sqrt{\varepsilon_{r2}}}\right)\left(1 - \left|\frac{1 - \sqrt{\varepsilon_{r2}}}{1 + \sqrt{\varepsilon_{r2}}}\right|^2\right)} \tag{3}$$

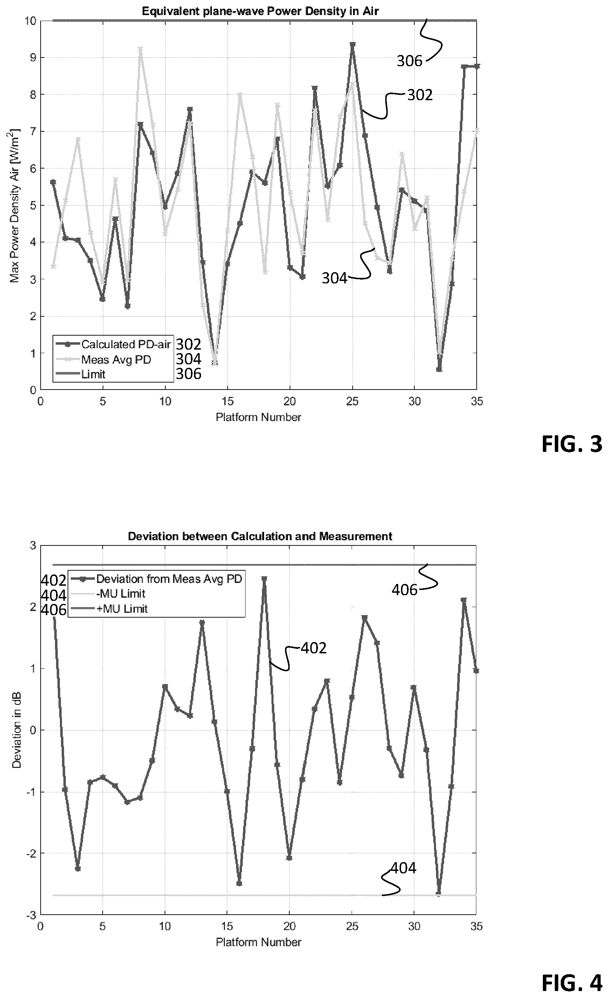

To validate this approach, Data were collected on 35 certified human tissue platforms. For each, the highest power density case was reported, and the measured incident power density was compared to the highest incident power density as calculated by the proposed methodology. FIG. 3 depicts the comparison of the calculated incident power density values to the measured incident power density values. In this figure, the calculated $PD_{air}$ is depicted as 302; the measured average power density is depicted as 304, and the regulatory limit is depicted as 306. It can be seen that although there is some deviation between the measured power density values and the calculated power density values, the calculated values largely track the measured values, and the calculation techniques disclosed herein represent a reasonable basis with which to determine power density. Using this procedure, power density can be calculated based on SAR, rather than performing power density measurements. Of note, the fact that each of the measurements and the calculated values are beneath the regulatory limit is a strong indication that the SAR-based calculations for power density as disclosed herein may be utilized in lieu of power density measures, while maintaining confidence that the regulatory limits will be maintained.

FIG. 4 depicts the deviation in dB between measured power density and calculated power density. In this figure, the deviation in dB was shown for each of 35 platforms tested. The deviation from the measured average power density (e.g., the difference between the measured power density and the calculated power density) in decibels is shown as 402. The upper measurement uncertainty limit is shown as 404, and the lower measurement uncertainty is shown as 406. These results show that the deviation between the estimated IPD ($PD_{air}$) (e.g. the "calculated" PD based on the SAR), as opposed to the measured PD is within measurement uncertainty limits of the PD measurement system. Of note, in this example, the measurement uncertainty limits are 2.7 dB, although the measurement uncertainty limits may differ (e.g. be set by a given manufacturer).

In viewing the results depicted in FIG. 4, the most significant deviation was observed for platform 32, in which the absolute IPD was very small i.e. around $1W/m^2$. In light of this very small value, it would be expected that there could be greater deviation. The majority of platforms tested (i.e., 66% (23 over 35)), have deviation within $\pm1dB$ between the calculated PD and the measured PD.

The principles described herein may optionally be performed by an incident power density determination device. This incident power density determination device may use or include a human tissue phantom. The human tissue phantom may be a device that is made of or that includes one or more materials that are configured to mimic the dielectric properties of human tissue. The human tissue phantom may optionally be configured as a human head and may mimic the dielectric properties of the human head.

The incident power density determination device and/or the human tissue phantom may include one or more radiofrequency probes. The one or more radiofrequency probes may be inserted into the human tissue phantom, or may be a part of or included within the human tissue phantom. The one or more radiofrequency probes may be used to measure and electric field within the human tissue phantom, as generated by radiofrequency emissions from a radiofrequency source within a near proximity of the human tissue phantom. For example, a mobile phone may be placed in close proximity to the human tissue phantom, and resulting electrical fields within the human tissue phantom may be measured by the one or more radiofrequency probes. Assuming that a plurality of radiofrequency probes is utilized, the plurality of radiofrequency probes may be stationary and may thus measure and electric field at their given locations. Additionally or alternatively, one or more radiofrequency probes may be mobile, and may be configured to be placed at specific locations within the human tissue phantom for measuring of the electric fields.

The results of the electric field measurements may be provided to a processor for further processing. The incident power density determination device may therefore include one or more front end devices for processing the electric field signals as detected at the one or more radiofrequency probes. For example, the front end device may include one or more amplifiers, configured to amplify a voltage corresponding to a detected electric field. The front end device may include one or more analog-to-digital converters, configured to generate a digital value representing a magnitude of the electric field detected by the one or more radiofrequency probes. A number of configurations for devices between the radiofrequency probes and the processor are conceivable, and the skilled person will appreciate the variety of options and will be capable of selecting an appropriate option for a given implementation.

The incident power density determination device may include a processor, which may be configured to determine an incident power density at an outer surface of the human tissue phantom based on the generated measurements of the radiofrequency emissions. The processor may do so by receiving measurements of the electric fields within the human tissue phantom, as detected by the one or more radiofrequency probes. These multiple measurements of the electric fields within the human tissue phantom, taken together, represent and electric field distribution within the human tissue phantom. Using the formulas disclosed herein, the processor may be configured to convert the electric field distribution to the incident power density distribution at the outer surface of the human tissue phantom.

The processor being configured to determine the incident power density at the outer surface of the human tissue phantom based on the generated measurements of the radiofrequency emissions may include the processor being configured to determine a power density beneath the exterior surface of the human tissue phantom using the generated measurements, and to determine the incident power density from the determined power density beneath the exterior surface of the human tissue phantom. This may be achieved using the formulas disclosed herein. Specifically, the processor may be configured to calculate the power density at an internal boundary of the human tissue phantom (e.g.,

$$PD_{body} = \frac{\|E_{body}\|^2}{Z_{body}} = \frac{\|E_{body}\|^2}{\left(\frac{120\pi}{\sqrt{\varepsilon_{r2}}}\right)} .$$

calculate $PD_{body}$) using the following formula:

In this manner, the processor may be configured to determine $PD_{body}$ using the one or more of the measurements of the radiofrequency signal (Electric-Field) absorbed within portions of the human tissue phantom, wherein the processor is configured to square a magnitude of the electric field vector and divide this amount by the body impedance. In the case of a human tissue phantom, the body impedance may be (120•π) / $\varepsilon_{r2}$, wherein $\varepsilon_{r2}$ is the dielectric permittivity of the human tissue phantom. That is, the processor may be configured to convert the power density beneath the exterior surface of the human tissue phantom to the incident power density using a transmission coefficient based on a dielectric permittivity of the human tissue phantom. The transmission coefficient may be

$$T = 1 - R = 1 - \left|\frac{1-\sqrt{\varepsilon_{r2}}}{1+\sqrt{\varepsilon_{r2}}}\right|^2$$

; wherein T is the transmission coefficient; R is the reflection coefficient; and $\varepsilon_{r2}$ is a dielectric permittivity of the human tissue phantom. In this manner, the processor may be configured to determine the incident power density at the outer surface of the human tissue phantom according to:

$$PD_{air} = \frac{PD_{body}}{T} = \frac{PD_{body}}{1-\left|\frac{1-\sqrt{\varepsilon_{r2}}}{1+\sqrt{\varepsilon_{r2}}}\right|^2} = \frac{\|E_{body}\|^2}{\left(\frac{120\pi}{\sqrt{\varepsilon_{r2}}}\right)\left(1-\left|\frac{1-\sqrt{\varepsilon_{r2}}}{1+\sqrt{\varepsilon_{r2}}}\right|^2\right)}$$

; wherien $PD_{air}$ is the equivalent plane wave incident power density; $PD_{body}$ is the equivalent plane wave power density beneath the exterior surface of the human tissue phantom; and T is the transmission coefficient based on $\varepsilon_{r2}$, which is the dielectric permittivity of the human tissue phantom.

The actions described herein related to the incident power density determination device may additionally or alternatively be performed by one or more computer code instructions which, if executed, cause one or more processors to perform the steps disclosed herein. In this manner, the incident power density determination device may be or include a non-transitory computer readable medium that contains instructions which, if executed, cause a processor to perform the incident power density determinations disclosed herein.

Specifically, the non-transitory computer readable medium may include instructions which, if executed by a processor, cause the processor to: receive measurements of radiofrequency emissions absorbed within a human tissue phantom; and determine an incident power density at an outer surface of the human tissue phantom based on the generated measurements of the radiofrequency emissions. Any other function or step disclosed herein with respect to the incident power density determination device may alternatively be caused to be performed by the instructions, such as the instructions saved on the non-transitory computer readable medium.

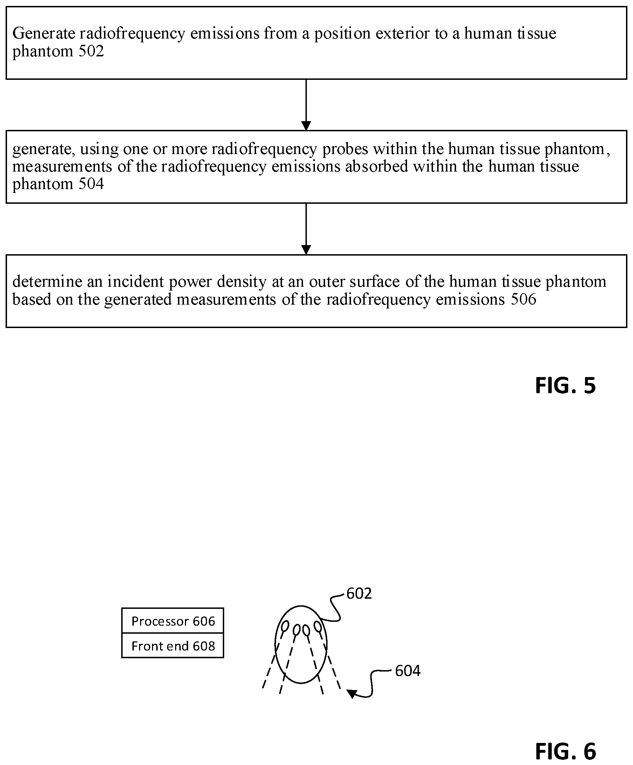

FIG. 5 depicts a method of incident power density determination, according to an aspect of the disclosure. The method may include generating radiofrequency emissions from a position exterior to a human tissue phantom 502; generating, using one or more radiofrequency probes within the human tissue phantom, measurements of the radiofrequency emissions absorbed within the human tissue phantom 504; and determining an incident power density at an outer surface of the human tissue phantom based on the generated measurements of the radiofrequency emissions 506. Any action disclosed relative to the incident power density determination device may be performed as a method step.

FIG. 6 depicts an incident power density determination device according to an aspect of the disclosure. The incident power density determination device may include a human tissue phantom 602, which may be configured to approximate dielectric properties of human tissue. The incident power density determination device or the human tissue phantom 602 may include one or more radiofrequency probes 602 (indicated in FIG. 6 with dashed lines). The one or more radiofrequency probes 602 may be positioned within the human tissue phantom and may be configured to generate measurements of radiofrequency emissions absorbed within the human tissue phantom. In particular, the one or more radiofrequency probes 604 may be configured to measure electric fields that are generated within the human tissue phantom 602 as a result of a radiofrequency emission from a radiofrequency source, external to the human tissue phantom 602.

The incident power density determination device may further include a processor 606, which may be configured to determine an incident power density at an outer surface of the human tissue phantom based on the generated measurements of the radiofrequency emissions. In this manner, the processor 606 may be configured to determine an electric field distribution from the multiple electric field measurements within the human tissue phantom 602. From this electric field vector, the processor 606 may be configured to calculate a power density within the human tissue phantom 602, such as a power density on an internal side of a boundary between the human tissue phantom 602 and surrounding air. The processor 606 may also be configured to determine from the power density within the human tissue phantom 602 a power density external to the human tissue phantom 602 (e.g., a power density on an outer / external portion of a boundary between the human tissue phantom 602 and surrounding air. The resulting power density calculations on the exterior surface of the human tissue phantom (e.g., the power density calculations in free space or air, immediately external to the human tissue phantom) form a power density distribution. The processor may be configured to determine the highest value of this power density distribution and compare this to a regulatory limit. That is, if the highest power density value is less than the regulatory limit for power density, then the underlying device may be understood to comply with the regulatory requirements for IPD. Conversely, if the highest power density value is greater than the regulatory limit for power density, then the underlying device may be understood not to comply with the regulatory requirements for IPD.

The device as disclosed herein may optionally include one or more sensing capabilities, such as one or more sensors to sense temperature, such as changes in temperature of the human tissue phantom upon exposure to electromagnetic emissions. In some circumstances, it may be optionally used with a live human, which may allow for one or more additional sensors, such as sensors to sense blood pressure and/or heart rate of the human subject, such as during radiofrequency exposure. It may include one or more sensors to sense electromagnetic/electric field strength (e.g., for wearable devices) that are non-invasive.

The incident power density determination device may optionally include a front end 608, which may include any of one or more amplifiers and/or one or more analog to digital converters. The front end 608 device may be configured to deliver to the processor a signal representing measured values of the electric field within the human tissue phantom 602.

The incident power density determination device may be a device for determining the IPD from measurements that are otherwise used for SAR. That is, by performing an SAR measurement across a bandwidth of a mobile device, the measured electric fields, which are a foundational aspect of SAR determination, can be reused to calculate the IPD at the outer boarder of the human tissue phantom. This greatly simplifies determination of the IPD as compared to conventional methods. The incident power density determination device as disclosed herein may be a device in which the process of IPD determination from electric field (SAR) measurements is reduced to a practical application. Moreover, the incident power density determination device as disclosed herein improves the underlying technology of IPD determination and simplifies IPD regulatory compliance.

Other aspects of the invention will be shown by way of example:

In Example 1, an incident power density determination device, including a human tissue phantom, configured to approximate dielectric properties of human tissue; one or more radiofrequency probes, positioned within the human tissue phantom, configured to generate measurements of radiofrequency emissions absorbed within the human tissue phantom; and a processor, configured to determine an incident power density at an outer surface of the human tissue phantom based on the generated measurements of the radiofrequency emissions.

In Example 2, the incident power density determination device of Example 1, further including a radiofrequency source, exterior to the human tissue phantom, configured to generate a radiofrequency emission for measurement by the one or more radiofrequency probes.

In Example 3, the incident power density determination device of Example 1 or 2, wherein the processor being configured to determine the incident power density at the outer surface of the human tissue phantom based on the generated measurements of the radiofrequency emissions includes the processor being configured to determine a power density beneath the exterior surface of the human tissue phantom using the generated measurements, and to determine the incident power density from the determined power density beneath the exterior surface of the human tissue phantom.

In Example 4, the incident power density determination device of Example 3, wherein the processor being configured to determine the power density beneath the exterior surface of the human tissue phantom using the generated measurements includes the processor determining the power density beneath the exterior surface of the human tissue

$$PD_{body} = \frac{\|E_{body}\|^2}{Z_{body}} = \frac{\|E_{body}\|^2}{\left(\frac{120\pi}{\sqrt{\varepsilon_{r2}}}\right)}$$

phantom according to: ; wherein $PD_{body}$ is the equivalent plane wave power density beneath the exterior surface of the human tissue phantom; $E_{body}$ corresponds to one or more of the measurements of the radiofrequency signal (Electric-Field) absorbed within portions of the human tissue phantom; and $\varepsilon_{r2}$ is a dielectic permittivity of the human tissue phantom.

In Example 5, the incident power density determination device of Example 3 or 4, wherein the processor being configured to determine the incident power density includes the processor being configured to convert the power density beneath the exterior surface of the human tissue phantom to the incident power density using a transmission coefficient based on a dielectric permittivity of the human tissue phantom.

In Example 6, the incident power density determination device of Example 5, wherein the transmission coefficient

$$T = 1 - R = 1 - \left|\frac{1 - \sqrt{\varepsilon_{r2}}}{1 + \sqrt{\varepsilon_{r2}}}\right|^2$$

is ; wherein T is the transmission coefficient; R is the reflection coefficient; and $\varepsilon_{r2}$ is a dielectric permittivity of the human tissue phantom.

In Example 7, the incident power density determination device of any one of Examples 1 to 6, wherein the processor being configured to determine the incident power density at the outer surface of the human tissue phantom includes the processor being configured to determine the incident power density according to:

$$PD_{air} = \frac{PD_{body}}{T} = \frac{PD_{body}}{1 - \left|\frac{1 - \sqrt{\varepsilon_{r2}}}{1 + \sqrt{\varepsilon_{r2}}}\right|^2} = \frac{\|E_{body}\|^2}{\left(\frac{120\pi}{\sqrt{\varepsilon_{r2}}}\right)\left(1 - \left|\frac{1 - \sqrt{\varepsilon_{r2}}}{1 + \sqrt{\varepsilon_{r2}}}\right|^2\right)}$$

; wherien $PD_{air}$ is the equivalent plane wave incident power density; $PD_{body}$ is the equivalent plane wave power density beneath the exterior surface of the human tissue phantom; and T is the transmission coefficient based on $\varepsilon_{r2}$, which is the dielectic permittivity of the human tissue phantom.

In Example 8, a non-transitory computer readable medium, including instructions which, if executed by a processor, cause the processor to: receive measurements of radiofrequency emissions absorbed within a human tissue phantom; and determine an incident power density at an outer surface of the human tissue phantom based on the generated measurements of the radiofrequency emissions.

In Example 9, the non-transitory computer readable medium of Example 8, wherein the instructions being configured to cause the processor to determine the incident power density at the outer surface of the human tissue phantom based on the generated measurements of the radiofrequency emissions includes the instructions being configured to cause the processor to determine a power density beneath the exterior surface of the human tissue phantom using the generated measurements, and to determine the incident power density from the determined power density beneath the exterior surface of the human tissue phantom.

In Example 10, the non-transitory computer readable medium of Example 9, wherein the instructions being configured to cause the processor to determine the power density beneath the exterior surface of the human tissue phantom using the generated measurements includes the instructions being configured to cause the processor to determine the power density beneath the exterior surface of the human tissue phantom according to: $PD_{body} =$

$$\frac{\|E_{body}\|^2}{Z_{body}} = \frac{\|E_{body}\|^2}{\left(\frac{120\pi}{\sqrt{\varepsilon_{r2}}}\right)}$$

; wherein $PD_{body}$ is the equivalent plane-wave power density beneath the exterior surface of the human tissue phantom; $E_{body}$ corresponds to one or more of the measurements of the radiofrequency signal (Electric Field) absorbed within portions of the human tissue phantom; and $\varepsilon_{r2}$ is a dielectric permittivity of the human tissue phantom.

In Example 11, the non-transitory computer readable medium of Example 9 or 10, wherein the instructions being configured to cause the processor to determine the incident power density includes the instructions being configured to cause the processor to convert the power density beneath the exterior surface of the human tissue phantom to the incident power density using a transmission coefficient based on a dielectric permittivity of the human tissue phantom.

In Example 12, the non-transitory computer readable medium of Example 11, wherein the transmission coefficient is

$$T = 1 - R = 1 - \left|\frac{1-\sqrt{\varepsilon_{r2}}}{1+\sqrt{\varepsilon_{r2}}}\right|^2$$

; whereinT is the transmission coefficient; R is the reflection coefficient and $\varepsilon_{r2}$ is a dielectric permittivity of the human tissue phantom.

In Example 13, the incident power density determination computer ? of any one of Examples 8 to 12, wherein the instructions being configured to cause the processor to determine the incident power density at the outer surface of the human tissue phantom includes the instructions being configured to cause the processor to determine the incident power density according to:

$$PD_{air} = \frac{PD_{body}}{T} = \frac{PD_{body}}{1-\left|\frac{1-\sqrt{\varepsilon_{r2}}}{1+\sqrt{\varepsilon_{r2}}}\right|^2} = \frac{\|E_{body}\|^2}{\left(\frac{120\pi}{\sqrt{\varepsilon_{r2}}}\right)\left(1-\left|\frac{1-\sqrt{\varepsilon_{r2}}}{1+\sqrt{\varepsilon_{r2}}}\right|^2\right)}$$

; wherien $PD_{air}$ is the equivalent plane wave incident power density; $PD_{body}$ is the equivalent plane wave power density beneath the exterior surface of the human tissue phantom; and T is the transmission coefficient based on $\varepsilon_{r2}$, which is a dielectric permittivity of the human tissue phantom.

In Example 14, a method of incident power density determination, including instructions which, if executed by a processor, cause the processor to: generate radiofrequency emissions from a position exterior to a human tissue phantom; generate, using one or more radiofrequency probes within the human tissue phantom, measurements of the radiofrequency emissions absorbed within the human tissue phantom; and determine an incident power density at an outer surface of the human tissue phantom based on the generated measurements of the radiofrequency emissions.

In Example 15, the method of incident power density determination of Example 14, further including generating the radiofrequency emissions with a radiofrequency source, and controlling the radiofrequency source to generate the radiofrequency emissions from a predetermined distance from the human tissue phantom.

In Example 16, the method of incident power density determination of Example 14 or 15, wherein the determining the incident power density at the outer surface of the human tissue phantom based on the generated measurements of the radiofrequency emissions includes determining a power density beneath an exterior surface of the human tissue phantom using the generated measurements, and determining the incident power density from the determined power density beneath the exterior surface of the human tissue phantom.

In Example 17, the method of incident power density determination of Example 16, wherein the determining the power density beneath the exterior surface of the human tissue phantom using the generated measurements includes determining the power density beneath the exterior surface of the human tissue phantom according to:

$$PD_{body} = \frac{\|E_{body}\|^2}{Z_{body}} = \frac{\|E_{body}\|^2}{\left(\frac{120\pi}{\sqrt{\varepsilon_{r2}}}\right)}$$

; wherein $PD_{body}$ is the power density beneath the exterior surface of the human tissue phantom; $E_{body}$ corresponds to one or more of the measurements of the radiofrequency signal absorbed within portions of the human tissue phantom; and $\varepsilon_{r2}$ is a dielectric permittivity of the human tissue phantom.

In Example 18, the method of incident power density determination of Example 16 or 17, wherein the determining the incident power density includes converting the power density beneath the exterior surface of the human tissue phantom to the incident power density using a transmission coefficient based on a dielectric permittivity of the human tissue phantom.

In Example 19, the method of incident power density determination of Example 18, wherein the transmission

$$T = 1 - R = 1 - \left| \frac{1-\sqrt{\varepsilon_{r2}}}{1+\sqrt{\varepsilon_{r2}}} \right|^2$$

coefficient is ; wherein T is the transmission coefficient R is the reflection coefficient and $\varepsilon_{r2}$ is a dielectric permittivity of the human tissue phantom.

In Example 20, the method of incident power density determination of any one of Examples 14 to 19, wherein the determining the incident power density at the outer surface of the human tissue phantom includes determining the incident

$$PD_{air} = \frac{PD_{body}}{T} = \frac{PD_{body}}{1-\left|\frac{1-\sqrt{\varepsilon_{r2}}}{1+\sqrt{\varepsilon_{r2}}}\right|^2} = \frac{\|E_{body}\|^2}{\left(\frac{120\pi}{\sqrt{\varepsilon_{r2}}}\right)\left(1-\left|\frac{1-\sqrt{\varepsilon_{r2}}}{1+\sqrt{\varepsilon_{r2}}}\right|^2\right)}$$

power density according to: ; wherien $PD_{air}$ is the incident power density; $PD_{body}$ is the power density beneath the exterior surface of the human tissue phantom; and T is the transmission coefficient based on $\varepsilon_{r2}$, which is a dielectric permittivity of the human tissue phantom.

While the above descriptions and connected figures may depict components as separate elements, skilled persons will appreciate the various possibilities to combine or integrate discrete elements into a single element. Such may include combining two or more circuits for form a single circuit, mounting two or more circuits onto a common chip or chassis to form an integrated element, executing discrete software components on a common processor core, etc. Conversely, skilled persons will recognize the possibility to separate a single element into two or more discrete elements, such as splitting a single circuit into two or more separate circuits, separating a chip or chassis into discrete elements originally provided thereon, separating a software component into two or more sections and executing each on a separate processor core, etc.

It is appreciated that implementations of methods detailed herein are demonstrative in nature, and are thus understood as capable of being implemented in a corresponding device. Likewise, it is appreciated that implementations of devices detailed herein are understood as capable of being implemented as a corresponding method. It is thus understood that a device corresponding to a method detailed herein may include one or more components configured to perform each aspect of the related method.

All acronyms defined in the above description additionally hold in all claims included herein.

**Claims**

1. An incident power density determination device, comprising:

   a human tissue phantom or human tissue phantoms, configured to approximate dielectric properties of human tissue;
   one or more radiofrequency probes, positioned within the human tissue phantom or the human tissue phantoms, configured to generate measurements of radiofrequency emissions absorbed within the human tissue phantom; and
   a processor, configured to determine an incident power density at an outer surface of the human tissue phantom or the human tissue phantoms based on the generated measurements of the radiofrequency emissions.

2. The incident power density determination device of claim **1,** further comprising a radiofrequency source, exterior to the human tissue phantom or the human tissue phantoms, configured to generate a radiofrequency emission for measurement by the one or more radiofrequency probes.

3. The incident power density determination device of any one of claims 1 or 2, wherein the processor being configured to determine the incident power density at the outer surface of the human tissue phantom or the human tissue phantoms based on the generated measurements of the radiofrequency emissions comprises the processor being configured to determine a power density beneath an exterior surface of the human tissue phantom or the human tissue phantoms using the generated measurements, and to determine the incident power density from the determined power density beneath the exterior surface of the human tissue phantom or the human tissue phantoms.

4. The incident power density determination device of claim 3, wherein the processor being configured to determine the power density beneath the exterior surface of the human tissue phantom or the human tissue phantoms using the generated measurements comprises the processor determining the power density beneath the exterior surface of the human tissue phantom or the human tissue phantoms according to:

$$PD_{body} = \frac{\|E_{body}\|^2}{Z_{body}} = \frac{\|E_{body}\|^2}{\left(\frac{120\pi}{\sqrt{\varepsilon_{r2}}}\right)};$$

wherein $PD_{body}$ is an equivalent plane wave power density beneath the exterior surface of the human tissue phantom or the human tissue phantoms; $E_{body}$ corresponds to one or more of the measurements of an electric field of the radiofrequency signal absorbed within portions of the human tissue phantom or the human tissue phantoms; and $\varepsilon_{r2}$ is a dielectic permittivity of the human tissue phantom.

5. The incident power density determination device of any one of claims 3 or 4, wherein the processor being configured to determine the incident power density comprises the processor being configured to convert the power density beneath the exterior surface of the human tissue phantom or the human tissue phantoms to the incident power density using a transmission coefficient based on a dielectric permittivity of the human tissue phantom or the human tissue phantoms.

6. The incident power density determination device of claim 5, wherein the transmission coefficient is

$$T = 1 - R = 1 - \left|\frac{1-\sqrt{\varepsilon_{r2}}}{1+\sqrt{\varepsilon_{r2}}}\right|^2$$ ; wherein T is the transmission coefficient; R is the reflection coefficient; and $\varepsilon_{r2}$ is a dielectric permittivity of the human tissue phantom or the human tissue phantoms.

7. The incident power density determination device of any one of claims 1 to 6, wherein the processor being configured to determine the incident power density at the outer surface of the human tissue phantom or the human tissue phantoms comprises the processor being configured to determine the incident power density according to:

$$PD_{air} = \frac{PD_{body}}{T} = \frac{PD_{body}}{1-\left|\frac{1-\sqrt{\varepsilon_{r2}}}{1+\sqrt{\varepsilon_{r2}}}\right|^2} = \frac{\|E_{body}\|^2}{\left(\frac{120\pi}{\sqrt{\varepsilon_{r2}}}\right)\left(1-\left|\frac{1-\sqrt{\varepsilon_{r2}}}{1+\sqrt{\varepsilon_{r2}}}\right|^2\right)}$$ ; wherien $PD_{air}$ is the equivalent plane wave incident power density; $PD_{body}$ is the equivalent plane wave power density beneath the exterior surface of the human tissue phantom or the human tissue phantoms; and T is the transmission coefficient based on $\varepsilon_{r2}$, which is the dielectric permittivity of the human tissue phantom or the human tissue phantoms.

8. A method of incident power density determination, comprising:

generating radiofrequency emissions from a position exterior to a human tissue phantom or human tissue phantoms;
generating, using one or more radiofrequency probes within the human tissue phantom or the human tissue phantoms, measurements of the radiofrequency emissions absorbed within the human tissue phantom or the human tissue phantoms; and
determining an incident power density at an outer surface of the human tissue phantom or the human tissue phantoms based on the generated measurements of the radiofrequency emissions.

9. The method of incident power density determination of claim 8, further comprising generating the radiofrequency emissions with a radiofrequency source, and controlling the radiofrequency source to generate the radiofrequency emissions from a predetermined distance from the human tissue phantom or the human tissue phantoms.

10. The method of incident power density determination of any one of claims 8 or 9, wherein the determining the incident power density at the outer surface of the human tissue phantom or the human tissue phantoms based on the generated measurements of the radiofrequency emissions comprises determining a power density beneath an exterior surface of the human tissue phantom or the human tissue phantoms using the generated measurements, and determining the incident power density from the determined power density beneath the exterior surface of the human tissue phantom or the human tissue phantoms.

11. The method of incident power density determination of claim 10, wherein the determining the power density beneath the exterior surface of the human tissue phantom or the human tissue phantoms using the generated measurements comprises determining the power density beneath the exterior surface of the human tissue phantom or the human tissue phantoms according to:

$$PD_{body} = \frac{\|E_{body}\|^2}{Z_{body}} = \frac{\|E_{body}\|^2}{\left(\frac{120\pi}{\sqrt{\varepsilon_{r2}}}\right)};$$

wherein $PD_{body}$ is the power density beneath the exterior surface of the human tissue phantom or the human tissue phantoms; $E_{body}$ corresponds to one or more of the measurements of the radiofrequency signal absorbed within portions of the human tissue phantom or the human tissue phantoms; and $\varepsilon_{r2}$ is a dielectric permittivity of the human tissue phantom or the human tissue phantoms.

12. The method of incident power density determination of any one of claims 10 or 11, wherein the determining the incident power density comprises converting the power density beneath the exterior surface of the human tissue phantom or the human tissue phantoms to the incident power density using a transmission coefficient based on a dielectric permittivity of the human tissue phantom or the human tissue phantoms.

13. The method of incident power density determination of claim 12, wherein the transmission coefficient is

$$T = 1 - R = 1 - \left|\frac{1-\sqrt{\varepsilon_{r2}}}{1+\sqrt{\varepsilon_{r2}}}\right|^2$$ ; wherein T is the transmission coefficient R is the reflection coefficient and $\varepsilon_{r2}$ is a dielectric permittivity of the human tissue phantom or the human tissue phantoms.

14. The method of incident power density determination of any one of claims 8 to 13, wherein the determining the incident power density at the outer surface of the human tissue phantom or the human tissue phantoms comprises determining

$$PD_{air} = \frac{PD_{body}}{T} = \frac{PD_{body}}{1-\left|\frac{1-\sqrt{\varepsilon_{r2}}}{1+\sqrt{\varepsilon_{r2}}}\right|^2} = \frac{\|E_{body}\|^2}{\left(\frac{120\pi}{\sqrt{\varepsilon_{r2}}}\right)\left(1-\left|\frac{1-\sqrt{\varepsilon_{r2}}}{1+\sqrt{\varepsilon_{r2}}}\right|^2\right)}$$ ; wherien

the incident power density according to: $PD_{air}$ is the incident power density; $PD_{body}$ is the power density beneath the exterior surface of the human tissue phantom or the human tissue phantoms; and T is the transmission coefficient based on $\varepsilon_{r2}$, which is a dielectric permittivity of the human tissue phantom or human tissue phantoms.

15. A non-transitory computer readable medium, comprising instructions which, if executed by a processor, cause the processor to implement a method of any one of claims 8 to 14.

| Perform SAR measurement of specific configuration 102 |
| --- |

$\downarrow$

| From the e-field vector ($E_{body}$) distribution obtained in the area scan step, calculate the body equivalent plane wave power density ($PD_{body}$) 104 |
| --- |

$\downarrow$

| Deduce the free space equivalent power density ($PD_{air}$) distribution at the boundary with the phantom using the estimated reflection coefficient 106 |
| --- |

$\downarrow$

| Find the peak of equivalent plane wave power density that will be compared to the limit of 10 W/m2 108 |
| --- |

**FIG. 1**

DUT ⌐202

Air (medium 1)

$\varepsilon_{r1}=1$

$PD_{air}$     $PD_{air}$

d

$PD_{body}$   $E_{body}$   $PD_{body}$

204

206

SAR Liquid (medium 2)

$\varepsilon_{r2}$

**FIG. 2**

**FIG. 3**

**FIG. 4**

Generate radiofrequency emissions from a position exterior to a human tissue phantom 502

generate, using one or more radiofrequency probes within the human tissue phantom, measurements of the radiofrequency emissions absorbed within the human tissue phantom 504

determine an incident power density at an outer surface of the human tissue phantom based on the generated measurements of the radiofrequency emissions 506

**FIG. 5**

Processor 606

Front end 608

602

604

**FIG. 6**

## EUROPEAN SEARCH REPORT

| | Application Number |
|---|---|
| | **EP 25 18 6699** |

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ZIANE MASSINISSA ET AL: "Novel Technique for In-Body Absorbed Power Density Assessment Based on Free-Space E-Field Measurement", IEEE TRANSACTIONS ON MICROWAVE THEORY AND TECHNIQUES, IEEE, USA, vol. 72, no. 7, 1 July 2024 (2024-07-01), pages 4127-4138, XP011974512, ISSN: 0018-9480, DOI: 10.1109/TMTT.2023.3336798 [retrieved on 2023-12-05] | 1,2,8,9, 15 | INV. G01R29/08 |
| A | * page 4127, left-hand column - page 4136, right-hand column; figures 1-5 * ----- | 3-7, 10-14 | |
| A | DERAT B ET AL: "Enhanced Simulation-Augmented OTA Technique Applied to Absorbed Power Density Evaluation", 2023 ANTENNA MEASUREMENT TECHNIQUES ASSOCIATION SYMPOSIUM (AMTA), AMTA, 8 October 2023 (2023-10-08), pages 1-6, XP034457834, DOI: 10.23919/AMTA58553.2023.10293421 [retrieved on 2023-10-31] * page 1 - page 5; figures 1-12 * ----- -/-- | 1-15 | |

| TECHNICAL FIELDS SEARCHED (IPC) |
|---|
| G01R |

The present search report has been drawn up for all claims

| Place of search | Date of completion of the search | Examiner |
|---|---|---|
| Munich | 15 December 2025 | Bilzer, Claus |

EPO FORM 1503 03.82 (P04C01)

## EUROPEAN SEARCH REPORT

Europäisches
Patentamt
European
Patent Office
Office européen
des brevets

**Application Number**

EP 25 18 6699

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | YAO MING ET AL: "Investigation of Criterion for Applying Incident Power Density in the Near-Field Region for EMF Assessment at Quasi-Millimeter and Millimeter-Wave Frequencies", IEEE TRANSACTIONS ON ELECTROMAGNETIC COMPATIBILITY, IEEE SERVICE CENTER , NEW YORK , NY, US, vol. 66, no. 3, 1 June 2024 (2024-06-01), pages 706-719, XP011972828, ISSN: 0018-9375, DOI: 10.1109/TEMC.2024.3371066 [retrieved on 2024-03-18] * page 706 - page 717; figures 1-9 * ----- | 1-15 | |
| A | ANDREAS CHRIST ET AL: "Limitations of Incident Power Density as a Proxy for Induced Electromagnetic Fields", BIOELECTROMAGNETICS, JOHN WILEY, NEW YORK, NY, US, vol. 41, no. 5, 14 May 2020 (2020-05-14), pages 348-359, XP071510365, ISSN: 0197-8462, DOI: 10.1002/BEM.22268 * page 348 - page 358; figures 1-10 * ----- | 1-15 | TECHNICAL FIELDS SEARCHED (IPC) |

The present search report has been drawn up for all claims

| Place of search | Date of completion of the search | Examiner |
|---|---|---|
| Munich | 15 December 2025 | Bilzer, Claus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................................

& : member of the same patent family, corresponding document

EPO FORM 1503 03.82 (P04C01)

page 2 of 2